# EUROPEAN PATENT APPLICATION

(11) **EP 4 835 497 A1**
(43) Date of publication of application: **04.11.2026**
(21) Application number: 25215389.5
(22) Date of filing: 12.11.2025
(51) Int. Cl.: G01R 19/14

(54) **BACKFLOW DETECTION CIRCUIT AND POWER SUPPLY DEVICE**

(30) Priority: 28.04.2025 CN 202520824235 U
(71) Applicant: Vertiv Tech Co., Ltd., Guangdong 518055 (CN)
(72) Inventor: WEI, Yunfeng, Shenzhen, 518055 (CN)
(74) Representative: Cousens, Nico

(57) **Abstract**

A backflow detection circuit and a power supply device for backflow fault detection in a high-power supply scenario and reducing the cost of a backflow detection device. The backflow detection circuit includes a transformer, an impedance module and an amplifier. A primary winding of the transformer is configured to be connected to a branch to be detected, and a secondary winding of the transformer is connected to the impedance module. The impedance module is connected to a processing device through the amplifier. The amplifier is configured to amplify an electrical parameter outputted by the impedance module and output the amplified electrical parameter to the processing device, so that the processing device performs backflow fault detection based on the electrical parameter outputted by the amplifier. The impedance module connected to the secondary winding of the transformer is configured to perform current limiting.

## Description

The present application claims priority to Chinese Patent Application No. 202520824235.6, titled "BACKFLOW DETECTION CIRCUIT AND POWER SUPPLY DEVICE", filed on April 28, 2025 with the China National Intellectual Property Administration.

### TECHNICAL FIELD

The present disclosure relates to the technical field of power electronics, and in particular to a backflow detection circuit and a power supply device.

### BACKGROUND

Backflow, overload, and short circuits are conventional fault types detected in power supply systems. As a power source module continues to increase in its power, the requirements for the size and cost of a fault detection component have become more stringent. Due to a rising current amplitude on a circuitry of the power source module, a current sampled by a transformer and coupled to a secondary winding of the transformer via a magnetic core exhibits a high amplitude after being outputted, causing a downstream connected detection device and a downstream connected processing device prone to damage. To ensure detection safety, a higher-cost device has to be provided to meet backflow detection requirements in a high-power supply scenario.

### SUMMARY

A backflow detection circuit and a power supply device are provided in the present disclosure, to meet the requirement of backflow fault detection on a device in a high-power supply scenario and reduce the cost of a backflow detection device.

In a first aspect, a backflow detection circuit is provided according to an embodiment of the present disclosure. The backflow detection circuit may be applied to a high-power supply device and is configured to determine whether a backflow fault occurs in a device. The backflow detection circuit may include a transformer, an impedance module and an amplifier.

A primary winding of the transformer is configured to be connected to a branch to be detected, and a secondary winding of the transformer is connected to the impedance module. The transformer is configured to detect an electrical parameter of the branch to be detected and output a detected value to the impedance module. The impedance module is connected to a processing device through the amplifier and is configured to: receive the electrical parameter outputted by the transformer, perform current limiting processing on the electrical parameter, and output the processed electrical parameter to the amplifier. The amplifier is configured to amplify the electrical parameter outputted by the impedance module and output the amplified electrical parameter to the processing device, so that the processing device performs backflow fault detection based on the electrical parameter outputted by the amplifier.

With the above design, the transformer in the backflow detection circuit may be implemented by a current transformer. A primary winding of the current transformer is connected in series to the branch to be detected, and a secondary winding of the current transformer is configured to be connected to the processing device through the impedance module and the amplifier. The branch to be detected may be a bypass branch of a power supply device. When a main circuit supplies power, no current flows through the bypass branch. If a current is detected by the primary winding of the current transformer during power supply by the main circuit, the processing device may perform backflow fault detection based on the current. When the bypass branch supplies power, an amplitude of a normal power-supply current is high. Therefore, an amplitude of a current outputted by the secondary winding of the current transformer is high, possibly causing device damage. The configured impedance module may perform current limiting processing on the current and then output the processed current to a downstream connected device, thereby meeting the requirement for backflow fault detection on the power supply device and ensuring device safety. By configuring only an impedance module, the requirement for detection on a high-power supply device is met while the cost of a backflow detection device is reduced.

A secondary current of the current transformer is generally determined based on a secondary voltage and a total impedance on a secondary side of the current transformer. With the configured impedance module, the total impedance on the secondary side is increased, limiting an amplitude of the secondary current of the current transformer and thereby protecting safety of a device on the secondary side of the current transformer. Compared with a conventional device model of which a secondary winding is adjusted, the backflow detection requirement in a high-power supply scenario is met by configuring only an impedance device, featuring a lower cost.

In a possible design, the impedance module includes a first resistor. A first terminal of the first resistor is connected to a first interface of the secondary winding of the transformer, and a second terminal of the first resistor is connected to a first input terminal of the amplifier. A second interface of the secondary winding of the transformer is connected to a second input terminal of the amplifier. In the above design, the first resistor is arranged on a path between the secondary winding of the transformer and the amplifier and therefore a total impedance on the secondary winding side is increased. In this way, the secondary current is limited within an amplitude at which the safety of a downstream connected device is ensured even if no parameter of the transformer is adjusted.

In a possible design, if the current limiting capability of a single resistor is insufficient to meet the backflow detection requirement of a high-power supply device, the impedance module further includes a second resistor. The second resistor is connected between the second interface of the secondary winding of the transformer and the second input terminal of the amplifier. A first terminal of the second resistor is connected to the second interface of the secondary winding of the transformer, and a second terminal of the second resistor is connected to the second input terminal of the amplifier.

In a possible design, the backflow detection circuit further includes a first diode and a second diode.

An anode of the first diode is connected to the first input terminal of the amplifier, and a cathode of the first diode is connected to the second input terminal of the amplifier. A cathode of the second diode is connected to the first input terminal of the amplifier, and an anode of the second diode is connected to the second input terminal of the amplifier. With the first diode and the second diode, an amplitude of the secondary voltage outputted by the transformer is high when the branch to be detected is closed and a power transmitted on it is high. To protect a device on the secondary side of the transformer from the high voltage, the first diode and the second diode are arranged between the first input terminal and the second input terminal of the amplifier. The first diode is configured to clamp a voltage at the first input terminal of the amplifier and the second diode is configured to clamp a voltage at the second input terminal of the amplifier, thereby protecting safety of the device on the secondary side of the transformer.

In a possible design, a saturation flux density of a magnetic core of the transformer is less than a first predetermined threshold. With the above design, an amplitude of the secondary voltage outputted by the transformer is generally related to an operating frequency, a cross-sectional area of the magnetic core, the saturation magnetic flux density of the magnetic core, and a turns ratio of the primary winding to the secondary winding. Therefore, the amplitude of the secondary voltage outputted by the transformer may be reduced by reducing the saturation magnetic flux density of the magnetic core, thereby reducing a current amplitude on the secondary winding side of the transformer.

In a possible design, the cross-sectional area of the magnetic core of the transformer is less than a second predetermined threshold. With the above design, the amplitude of the secondary voltage outputted by the transformer is generally related to the operating frequency, the cross-sectional area of the magnetic core, the saturation magnetic flux density of the magnetic core, and the turns ratio of the primary winding to the secondary winding. Therefore, an amplitude of a voltage outputted by the secondary winding may be reduced by reducing the cross-sectional area of the magnetic core of the transformer, thereby reducing the current amplitude on the secondary winding side. In addition, the reduced cross-sectional area of the magnetic core of the transformer results in a shortened coil winding path of the transformer, further reducing the device cost and the size of the backflow detection circuit.

In a possible design, the number of turns of the secondary winding of the transformer is less than a third predetermined threshold. With the above design, the amplitude of the secondary voltage outputted by the transformer is generally related to an operating frequency, the cross-sectional area of the magnetic core, the saturation magnetic flux density of the magnetic core, and the turns ratio of the primary winding to the secondary winding. Therefore, a transformation ratio between a primary voltage and the secondary voltage of the transformer may be reduced through reducing the number of coils of the secondary winding, thereby reducing the amplitude of the secondary voltage on the secondary winding side and ensuring safe device operating.

In a possible design, the backflow detection circuit further includes a processing device. The processing device is connected to an output terminal of the amplifier and is configured to determine, in a case that the branch to be detected is in a disconnected state and the electrical parameter outputted by the amplifier is determined to be greater than a predetermined value, that a backflow fault occurs in a device where the branch to be detected is arranged.

In a possible design, the amplifier is configured to output an analog electrical signal which cannot be directly processed by the processing device. Therefore, the backflow detection circuit further includes an analog-to-digital converter connected between the amplifier and the processing device. The analog-to-digital converter is configured to convert the analog electrical signal outputted by the amplifier into a digital signal that can be processed by the processing device.

In a second aspect, a power supply device is provided according to an embodiment of the present disclosure. The power supply device is configured to be connected to one or more power-consuming devices to meet high-power electricity consumption requirements of the power-consuming devices. The power supply device may include an Uninterruptible Power Supply (UPS) and the backflow detection circuit provided in the first aspect and any possible design thereof.

An input terminal of the UPS is configured to be connected to a power source, and an output terminal of the UPS is configured to be connected to a load. The backflow detection circuit is connected to the UPS.

In addition, the technical effects brought by the second aspect and any possible design thereof may be referred to the technical effects brought by the various designs in the first aspect according to the embodiments of the present disclosure and are not described in further detail here.

### BRIEF DESCRIPTION OF THE DRAWINGS

To describe the technical solutions in embodiments of the present disclosure more clearly, the following briefly describes the drawings to be used in the embodiments. Apparently, the drawings in the following description show merely some embodiments of the present disclosure, and those skilled in the art may obtain other drawings based on these drawings without any creative effort.
FIG. 1 is a schematic structural diagram of a backflow detection circuit according to an embodiment of the present disclosure;
FIG. 2 is a schematic structural diagram of a backflow detection circuit according to another embodiment of the present disclosure;
FIG. 3 is a schematic structural diagram of an impedance module according to an embodiment of the present disclosure;
FIG. 4 is a schematic structural diagram of an impedance module according to another embodiment of the present disclosure; and
FIG. 5 is a schematic structural diagram of a power supply device according to an embodiment of the present disclosure.

### DETAILED DESCRIPTION

Embodiments of the present application are described in detail below in conjunction with the drawings.

The terms in the embodiments of the present disclosure are only for the purpose of explaining embodiments of the present disclosure, rather than limiting the present disclosure. Apparently, the described embodiments are only some rather than all of the embodiments of the present disclosure. Based on the embodiments of the present disclosure, all other embodiments obtained by those skilled in the art without any creative effort fall within the protection scope of the present disclosure.

It should be noted that the terms "first", "second" and the like in the specification, the claims and the drawings of the present disclosure are used to distinguish similar objects rather than to describe a particular sequence or order. It should be understood that the terms are interchangeable under appropriate circumstances such that the embodiments of the present disclosure described herein can be implemented in sequences different from those illustrated or described herein. The following exemplary embodiments do not include all the embodiments consistent with the present disclosure. On the contrary, the following embodiments only show examples of device and method consistent with some aspects of the present disclosure as detailed in the claims.

Technical solutions of embodiments of the present disclosure are clearly and completely described hereinafter in conjunction with the drawings of the embodiments of the present disclosure. The backflow detection circuit according to embodiments of the present disclosure may be applied to a power supply device. The backflow detection circuit may be connected to a power supply path of the power supply device and is configured to determine whether a backflow fault occurs in the power supply device through detecting whether a reverse current is generated on the power supply path. The power supply device may be arranged with a bypass branch and be configured to output alternating-current electrical energy for power supply. For example, the power supply device is implemented by an Uninterruptible Power System (UPS). The backflow detection circuit may be configured to be connected to a bypass branch of the UPS and determine whether a backflow fault occurs in the power supply device by detecting a current amplitude on the bypass branch during power supplying by a main circuit.

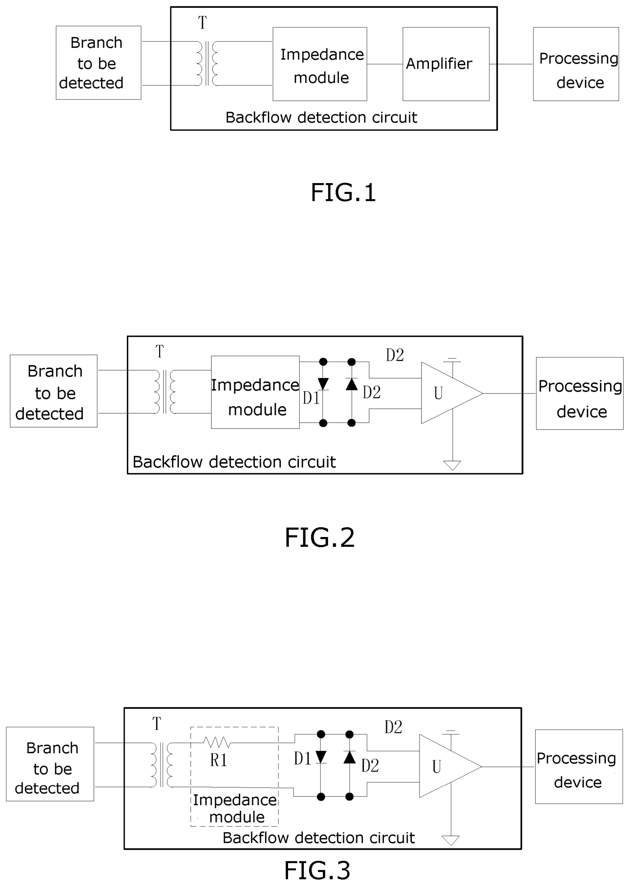

Reference is made to FIG. 1, which is schematic structural diagram of a backflow detection circuit according to an embodiment of the present disclosure. As shown in FIG. 1, the backflow detection circuit may include a transformer T, an impedance module, and an amplifier U.

A primary winding of the transformer T may be configured to be connected to a branch to be detected, and a secondary winding of the transformer T is connected to the impedance module. The transformer T is configured to detect an electrical parameter of the branch to be detected and output a detected value to the impedance module. The impedance module is configured to be connected to a downstream processing device through the amplifier U and is configured to: receive the electrical parameter outputted by the transformer T, perform current limiting processing on the electrical parameter, and output the processed electrical parameter to the amplifier U. The amplifier U is configured to amplify the electrical parameter outputted by the impedance module and output the amplified electrical parameter to the processing device, so that the processing device performs backflow fault detection based on the electrical parameter outputted by amplifier U.

It should be understood that the structure of the backflow detection circuit shown in FIG. 1 is only an example. The backflow detection circuit may be arranged with more components than those shown in FIG. 1. For example, the secondary winding of the transformer T in the backflow detection circuit is configured to be connected to another processing device for short circuit or leakage detection on the power supply device. The backflow detection circuit may further include other functional devices, which are not elaborated in the present disclosure.

A branch to be detected may be a bypass branch of a power supply device, and the bypass branch may serve as a power supply path between a power source and a load. In the case of good power supply quality of the power source, the bypass branch may be conducted and directly supplies electrical energy of the power source to a load. In the case of poor power supply quality of the power source, the bypass branch may be disconnected and a main power supply circuit in the power supply device may be conducted. An internal device of the main power supply circuit may perform conversion on electrical energy of the power source and then supply the electrical energy to the load to meet the requirements of the load for electrical energy. The backflow detection circuit may detect a current on the bypass branch through the transformer T when the power supply device is operating, and determine whether a backflow fault occurs in the power supply device based on the detected current.

The backflow detection circuit according to an embodiment of the present disclosure is configured to perform backflow fault detection by detecting whether a reverse current is generated on a bypass branch. Therefore, the transformer T configured to be connected to the branch to be detected may be implemented by a current transformer. A primary winding of the current transformer is connected in series to a bypass branch of a power supply device, and a secondary winding of the current transformer is configured to be connected to a processing device through an impedance module and an amplifier U. When the power supply device is operating and a current flows through the bypass branch, the current flows through the primary winding of the current transformer connected in series to the bypass branch. The current transformer may couple the current flowing through the primary winding to the secondary winding. A device connected to the secondary winding processes the electrical signal and outputs the processed electrical signal to the processing device. The processing device may perform backflow fault detection on the power supply device based on the outputted electrical signal.

Specifically, a power supply device supplies power through a main circuit or a bypass branch. When the power supply device supplies power through the bypass branch, the bypass branch is closed, the main circuit is disconnected, and a power supply current flows through the bypass branch. A processing device does not perform backflow fault detection based on a received electrical signal. When the power supply device supplies power through the main circuit, the bypass branch is disconnected and the main circuit is closed. Under normal circumstances, the bypass branch is in a disconnected state and no current flows through it. If an electrical parameter that is outputted by an amplifier and greater than a predetermined value is detected, it is determined that a current on the main circuit backflows to the bypass branch, indicating that a backflow fault occurs in the power supply device. The predetermined value may be set based on a parameter of an internal device of the power supply device, which is not limited in the present disclosure.

In an embodiment, for a power supply device configured with a monitoring system, the backflow detection circuit according to the embodiments of the present disclosure is applied to the monitoring system of the power supply device. The backflow detection circuit is configured to be connected to a processing device in the monitoring system, and the processing device in the monitoring system performs backflow fault detection. The monitoring system may further be connected to a short-circuit detection circuit, a leakage protection circuit and other fault detection circuits, which is not detailed in the present disclosure.

The backflow detection circuit may be fixed to the monitoring system, the monitoring system may be configured with a fixed interface, and the power supply device may be connected to the primary winding of the transformer T through the fixed interface and a cable. The backflow detection circuit may be fixed to the power supply device, the power supply device may be configured with a fixed interface, and the monitoring system may be connected to an output terminal of an amplifier through the fixed interface and a cable. In another implementation, the backflow detection circuit may be implemented in a detachable manner so that the power supply device and the monitoring system are flexibly connected to the backflow detection circuit. In the implementation, the backflow detection circuit may be independent of the monitoring system and the power supply device.

With the backflow detection circuit according to the embodiments of the present disclosure, in a case that a branch to be detected is a bypass branch of a power supply device, the power supply device is operating and a current flows through the branch to be detected, the current flows through coils of the primary winding of the transformer T and generates an electric field. The electric field is magnetically coupled to the secondary winding of the transformer T through a magnetic core, generating a secondary current I2 and a secondary voltage V2. When closed, the bypass branch supplies power and a normal power-supply current flows through the coils of the primary winding of the transformer T. Backflow fault detection is not performed based on the secondary current I2 outputted by the secondary winding of the transformer T. When the bypass branch is disconnected and the main circuit is closed, the main circuit supplies power. Under normal circumstances, no current flows through the bypass branch. If a reverse current is generated on the bypass branch, the reverse current may be coupled to the secondary side winding of the transformer T. A processing device connected to the backflow detection circuit may accurately determine, based on the secondary current I2 outputted from the secondary winding, whether a backflow fault occurs in the power supply device.

Referring to FIG. 1, when the power supply device starts to operate and the bypass branch supplies power, an amplitude of a normal power-supply current on the bypass branch is large. As a result, the secondary current I2 and the secondary voltage V2 outputted by the transformer T may cause device damage. The impedance module including a resistance component may perform current limiting processing on the secondary current I2 outputted by the secondary winding of the transformer T, thereby ensuring the internal device safety of the backflow detection circuit. As a current amplitude of the backflow detection circuit is limited by the impedance module, even if the current amplitude on the secondary winding side exceeds the demand of the amplifier U and other connected devices for an operating current, an electrical signal outputted by the impedance module after current limiting processing ensures that the amplifier U and other devices operate normally, thereby improving the operating stability of the backflow detection circuit. Furthermore, the cost of the impedance device is lower than that of changing the specification of a device connected to the secondary winding, thereby reducing the operating cost of the backflow detection circuit.

The current limiting effect of the impedance module may be optimized by configuring an impedance device with an appropriate resistance in the impedance module. For a backflow detection circuit functioning as an independent device, an adjustable resistor, for example, a sliding resistor, may be configured in the impedance module. In a case that the backflow detection circuit is configured to be connected to power supply devices with different power levels, a resistance of the sliding resistor may be adjusted to meet the demand of the power supply device for backflow detection.

In conjunction with the above description, backflow fault detection on a power supply device is performed through determination by a processing device based on an electrical signal detected by a backflow detection circuit. The backflow detection circuit may be configured to externally connect to an processing device, for example, an monitoring system. Alternatively, the backflow detection circuit according to the embodiments of the present disclosure may further include a processing device internally. The processing device may be connected to an output terminal of the amplifier U and may be configured to perform backflow fault detection based on an electrical signal outputted by the amplifier U.

A process of performing current limiting on an electrical signal outputted by the secondary side of the transformer T is described in detail below with reference to embodiments.

A backflow detection circuit is generally applied in a high-power supply scenario. During operating of a power supply device, an amplitude of the secondary voltage V2 outputted by the transformer T may be high. To protect a device on the secondary winding side from damage due to a high voltage, a clamping device is provided on the secondary winding side of the transformer T. The clamping device may clamp the amplitude of the secondary voltage outputted from the secondary winding side to the downstream device. The clamping device may be implemented by a diode or another device provided with the above function in the industry. Taking clamping device implemented by a diode as an example, referring to FIG. 2, in addition to the above devices, the backflow detection circuit according to the embodiments of the present disclosure may further include a first diode D1 and a second diode D2. An anode of the first diode D1 is connected to the first input terminal of an amplifier U, and a cathode of the first diode D1 is connected to the second input terminal of the amplifier U. A cathode of the second diode D2 is connected to the first input terminal of the amplifier U, and an anode of the second diode D2 is connected to the second input terminal of the amplifier U.

Referring to FIG. 2, when the secondary voltage V2 outputted by the transformer T is transmitted to an input terminal of the amplifier U through the impedance module, the first diode D1 or the second diode D2 is conducted based on a conduction condition. Thus, a voltage at the input terminal of the amplifier U is clamped to a conduction voltage of the conducted diode.

With the backflow detection circuit shown in FIG. 2, when the power supply device starts to operate, a current flowing through the primary winding of the transformer T is coupled to the secondary winding of the transformer T through a magnetic core. The secondary current I2 and the secondary voltage V2 outputted by the secondary winding of the transformer T satisfy the following formulas: $V 2 = 4.44 * N 2 * A * f * Bs$ (Formula 1) $I 2 = \left(V2-Vd\right) / Z$ (Formula 2)

In the formulas, N2 represents the number of turns of the secondary winding of the transformer T, A represents a cross-sectional area of the magnetic core of the transformer T, f represents an operating frequency of the transformer T, Bs represents a saturation magnetic flux density of the magnetic core of the transformer T, Vd represents a clamping voltage of a secondary-side diode of the transformer T, and Z represents a total impedance on a path from the diode and the secondary winding.

It can be seen from the above formulas 1 and 2 that an amplitude of the secondary current I2 outputted by the transformer T is determined based on the secondary voltage V2 and the total impedance Z on the path from the diode and the secondary winding. Due to the impedance module additionally arranged on the path from the diode to the primary winding, the total impedance Z on the path from the diode and the secondary winding is equal to a sum of an internal resistance r of the secondary winding and an impedance of the impedance module. In comparison with the prior art with only internal resistance, the total impedance on the secondary winding side according to the present disclosure is increased. Therefore, the amplitude of the secondary current I2 on a path on the secondary winding side of the transformer T is reduced while the amplitude of the voltage V2 outputted by the second winding remains unchanged. In this way, a device on the second winding side is protected from damage caused by overcurrent.

The impedance module may include at least one resistor, for example, a first resistor R1, as shown in FIG. 3. A first terminal of the first resistor R1 is connected to a first interface of the secondary winding of the transformer T, and a second terminal of the first resistor R1 is connected to the first input terminal of the amplifier U. The second interface of the secondary winding of the transformer T is connected to the second input of the amplifier U. For the backflow detection circuit configured with the first resistor R1, the secondary current I2 of the transformer T is equal to (V2-Vd)/(R1+r). Thus, as the resistance on the path from the secondary winding to the clamping diode is increased, the amplitude of the secondary current I2 on the path on the secondary side of the transformer T is reduced.

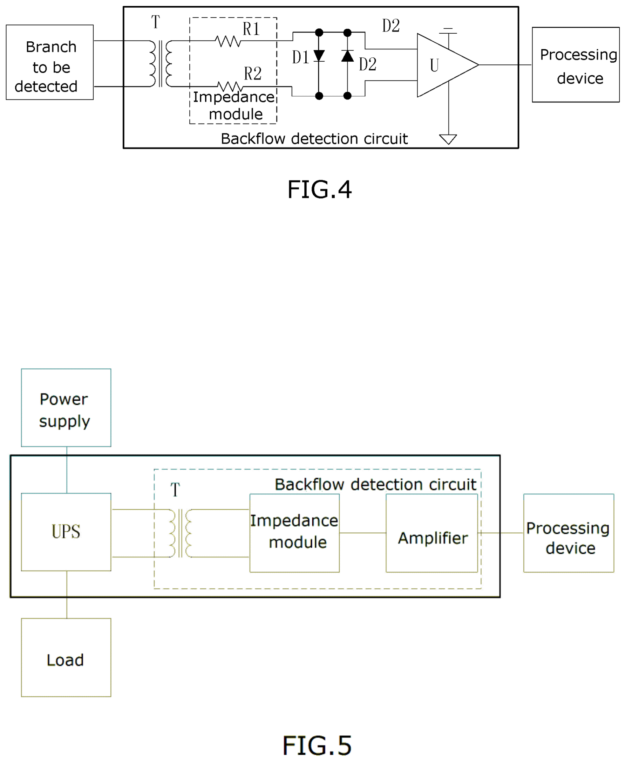

In an example, in a case that a resistance of a single resistor does not meet the requirement, the impedance module further includes a second resistor R2 connected between a second interface of the secondary winding of the transformer T and the second input terminal of the amplifier U, as shown in FIG. 4. A first terminal of the second resistor R2 is connected to the second interface of the secondary winding of the transformer T, and a second terminal of the second resistor R2 is connected to the second input terminal of the amplifier U. In this case, the secondary current I2 of the transformer T is equal to (V2-Vd)/(R1+R2+r). Since the resistance on the path from the secondary winding and the clamping diode is further increased, the amplitude of the secondary current I2 on the path on the secondary side of the transformer T is further reduced.

The first resistor R1 and the second resistor R2 may be provided with fixed resistances. The specifications of the first resistor R1 and the second resistor R2 may be configured based on a current amplitude on the path on the secondary side when a bypass branch supplies power and the model of each device in the backflow detection circuit. The first resistor R1 and the second resistor R2 may be implemented by adjustable resistors, for example, sliding rheostats. Resistances of the first resistor R1 and the second resistor R2 may be adjusted to meet the requirements of different power supply devices for backflow fault detection.

It should be understood that the above description of the impedance module is only an example, and the impedance module may be implemented in another circuit structure. For example, the first resistor R1 and the second resistor R2 in the impedance module may be implemented by multiple resistors connected in series. The impedance module may be implemented by another device provided with a current function and commonly used in the industry, which is not limited in present disclosure.

As shown in FIGS. 1 to 4, the backflow detection circuit according to the embodiments of the present disclosure may be configured with an additional impedance module to increase the total impedance Z on the secondary winding side, thereby reducing the secondary current I2 on the secondary side of the transformer T. It can be seen from the above formula 2 that the amplitude of the secondary current I2 is related to the secondary voltage V2, and therefore the output current I2 of the secondary winding may be reduced by reducing the amplitude of the secondary voltage V2. In conjunction with formula 1, it can be seen that the output voltage V2 of the secondary side of the transformer T is related to the number of turns N2 of the secondary winding, the cross-sectional area A of the magnetic core and the saturation magnetic flux density Bs of the magnetic core. Therefore, the secondary current I2 of the transformer T may be reduced by adjusting the above parameters of the transformer T.

In an implementation, the saturation magnetic flux density of the magnetic core of the transformer T is less than a first predetermined threshold. That is, a material with a low saturation magnetic density and a high magnetic permeability may be adopted as the magnetic core to reduce the output voltage V2 of the secondary winding, thereby furthering reducing the secondary current I2 on the secondary side of the transformer T. The first predetermined threshold may be set based on a parameter of the transformer T and a parameter of a downstream device connected to the impedance module. It is assumed that a current allowed to flow through the device connected to the impedance module is 3mA, the output voltage V2 of the secondary winding is 10.7V when the magnetic flux density of the magnetic core of the transformer T is 10000T, and a total impedance Z on a path from the secondary winding to a diode is 2KΩ. Thus, an amplitude of a current received by the downstream device connected to the impedance module is about 5mA, and the first predetermined threshold may be set to 5000T. It can be seen from the formula 1 and formula 2 that the amplitude of the current received by the downstream device connected to the impedance module is about 2.35mA at which the downstream device connected to the impedance module operates normally.

In an implementation, the cross-sectional area of the magnetic core of the transformer T is less than a second predetermined threshold. It should be noted that lessening the cross-sectional area of the magnetic core is conducive to reduce the winding diameter of the transformer T, the amplitude of the secondary current I2 and the size and cost of the transformer T. The second predetermined threshold may be set based on a parameter of the transformer T and a parameter of a downstream device connected to the impedance module. It is assumed that a current allowed to flow through the downstream device connected to the impedance module is 3mA, the output voltage V2 of the secondary winding is 10.7V when the cross-sectional area of the magnetic core of the transformer T is 2500mm², and the total impedance Z on the path from the secondary winding to the diode is 2KΩ. Thus, the amplitude of the current received by the downstream device connected to the impedance module is about 5mA, and the second predetermined threshold may be set to 1250mm². It can be seen from the formula 1 and formula 2 that the amplitude of the current received by the downstream device connected to the impedance module is about 2.35mA at which the downstream device connected to the impedance module operates normally.

In an implementation, the number of turns of the secondary winding of the transformer T is less than a third predetermined threshold. It should be noted that lessening the number of turns of the secondary winding is conducive to reduce the winding diameter of the secondary winding of the transformer T, the amplitude of the secondary current I2, and the size and cost of the transformer T. The third predetermined threshold may be set based on a parameter of the transformer T and a parameter of a downstream device connected to the impedance module. It is assumed that the current allowed to flow through the downstream device connected to the impedance module is 3mA, the output voltage V2 of the secondary winding is 10.7V when the number of turns of the second winding of the transformer T is 100, and the total impedance Z on the path from the secondary winding to the diode is 2KΩ. Thus, the amplitude of the current received by the downstream device connected to the impedance module is 5mA, and the third predetermined threshold may be set to 50. It can be seen from the formula 1 and formula 2 that the amplitude of the current received by the downstream device connected to the impedance module is about 2.35mA at which the downstream device connected to the impedance module operates normally.

Based on the above description, a power supply device is further provided according to an embodiment of the present disclosure. The power supply device may be connected between a power source and a load. The power supply device may be configured to control an electrical connection between the power source and the load. In a case that an output voltage of the power source is different from a power supply voltage required by the load, the power supply device may convert the output voltage of the power source and then output it to the load, so as to meet the power requirements of the load. Referring to FIG. 5, the power supply device may include a UPS and the aforementioned backflow detection circuit.

Specifically, an input terminal of the UPS is configured to be connected to a power source, and an output terminal of the UPS is configured to be connected to a load. The backflow detection circuit is connected to a bypass branch in the UPS. The structure of the backflow detection circuit may refer to the above description and is not repeated herein.

In an implementation, the UPS further includes an energy storage battery pack or the UPS may be configured to externally connect to the energy storage battery pack. During normal operating of an alternating-current power source externally connected to the UPS, the UPS is configured to, by using electrical energy of the alternating-current power source, supply power to a downstream connected load and charge the energy storage battery pack. In a case that the alternating-current power source externally connected to the UPS malfunctions, the UPS is configured to supply power, by using the electrical energy of the energy storage battery pack, to the downstream connected load to improve the power supply stability of the UPS.

The backflow detection circuit and the UPS may be integrated inside a cabinet. The cabinet is configured with a power interface and a load interface. An external power source may be connected to a power supply device through the power interface, and a load may be connected to the power supply device through the load interface to obtain electrical energy. The cabinet may further include other interfaces. An external device may be connected to the backflow detection circuit and the UPS through the above interfaces. For example, the cabinet may further include an interface for detecting leakage and an interface for connecting to a monitoring system.

In some implementations, in a cabinet where the backflow detection circuit and the UPS are integrated, the backflow detection circuit and a device in a power supply device may be arranged on a same Printed circuit board (PCB) or on different PCBs.

It should be noted that the power supply device including the UPS shown in FIG. 5 is merely an example. The power supply device may include a switching power supply structure arranged with a bypass branch and be configured to output an alternating-current current to supply power, which is not limited in the present disclosure.

Apparently, those skilled in the art may make various modifications and variations to the present disclosure without departing from the protection scope of the present claims.

## Claims

1. A backflow detection circuit, comprising a transformer (T), an impedance module and an amplifier (U), wherein
a primary winding of the transformer is configured to be connected to a branch to be detected, a secondary winding of the transformer is connected to the impedance module, and the transformer is configured to detect an electrical parameter of the branch to be detected and output a detected value to the impedance module;
the impedance module is connected to a processing device through the amplifier, and the impedance module is configured to: receive the electrical parameter outputted by the transformer, perform current limiting processing on the detected electrical parameter, and output the processed electrical parameter to the amplifier; and
the amplifier is configured to amplify the electrical parameter outputted by the impedance module and output the amplified electrical parameter to the processing device.

2. The backflow detection circuit according to claim 1, wherein the impedance module comprises a first resistor (R1), wherein
a first terminal of the first resistor is connected to a first interface of the secondary winding of the transformer, and a second terminal of the first resistor is connected to a first input terminal of the amplifier; and
a second interface of the secondary winding of the transformer is connected to a second input terminal of the amplifier.

3. The backflow detection circuit according to claim 2, wherein the impedance module further comprises a second resistor (R2) that is connected between the second interface of the secondary winding of the transformer and the second input terminal of the amplifier.

4. The backflow detection circuit according to any one of claims 1 to 3, further comprising a first diode (D1) and a second diode (D2), wherein
an anode of the first diode is connected to a first input terminal of the amplifier, and a cathode of the first diode is connected to a second input terminal of the amplifier; and
a cathode of the second diode is connected to the first input terminal of the amplifier, and an anode of the second diode is connected to the second input terminal of the amplifier.

5. The backflow detection circuit according to any one of claims 1 to 4, wherein a saturation flux density of a magnetic core of the transformer is less than a first predetermined threshold.

6. The backflow detection circuit according to any one of claims 1 to 5, wherein a cross-sectional area of a magnetic core of the transformer is less than a second predetermined threshold.

7. The backflow detection circuit according to any one of claims 1 to 6, wherein the number of turns of the secondary winding of the transformer is less than a third predetermined threshold.

8. The backflow detection circuit according to any one of claims 1 to 7, further comprising the processing device, wherein
the processing device is connected to an output terminal of the amplifier and is configured to:
determine, in a case that the branch to be detected is in a disconnected state and the electrical parameter outputted by the amplifier is detected to be greater than a predetermined value, that a backflow fault occurs in a device where the branch to be detected is arranged.

9. The backflow detection circuit according to claim 8, further comprising an analog-to-digital converter connected between the amplifier and the processing device.

10. A power supply device, comprising: a UPS and the backflow detection circuit according to any one of claims 1 to 9, wherein
an input terminal of the UPS is configured to be connected to a power source, and an output terminal of the UPS is configured to be connected to a load; and
the backflow detection circuit is connected to the UPS.
